# EUROPÄISCHE PATENTSCHRIFT

(11) **EP 3 673 094 B1**
(45) Veröffentlichungstag und Bekanntmachung des Hinweises auf die Patenterteilung: **20.05.2026**
(21) Anmeldenummer: 18753383.1
(22) Anmeldetag: 08.08.2018
(51) Int. Cl.: C23C 14/00, C23C 14/02, C23C 14/16, C23C 14/20, C23C 14/26, C23C 14/30, C23C 14/35, C23C 14/56

(54) **VERFAHREN ZUM HERSTELLEN EINER ELEKTRISCH LEITFÄHIGEN FOLIE**
METHOD FOR PRODUCING AN ELECTRICALLY CONDUCTIVE FOIL
PROCÉDÉ POUR FABRIQUER UNE FEUILLE ÉLECTROCONDUCTRICE

(30) Priorität: 23.08.2017 DE 102017119308
(43) Veröffentlichungstag der Anmeldung: 01.07.2020
(73) Patentinhaber: Fraunhofer-Gesellschaft zur Förderung der angewandten Forschung e.V., 80686 München (DE)
(72) Erfinder: SCHILLER, Nicolas, 01833 Stolpen OT Helmsdorf (DE); STRAACH, Steffen, 01187 Dresden (DE); FAHLAND, Matthias, 01257 Dresden (DE); STEINER, Cindy, 01097 Dresden (DE); RETHBERG, Sebastian, 01277 Dresden (DE)
(86) Internationale Anmeldenummer: PCT/EP2018/071564
(87) Internationale Veröffentlichungsnummer: WO 2019/038093

(56) Entgegenhaltungen:
- EP-A2- 0 415 206
- WO-A1-2017/054889
- DE-A1- 1 446 270
- JP-A- 2007 307 767

## Beschreibung

Die Erfindung betrifft ein Verfahren zum Herstellen einer elektrisch leitfähigen Folie. Eine Folie im Erfindungssinn bezeichnet ein flächiges, maximal 1,5 mm dickes, sich selbst tragendes und flexibles Gebilde aus einem über die Fläche betrachtet homogenen Material, welches seine wesentlichen Materialeigenschaften auch nach mehrmaligem Biegen oder Rollen nicht verliert.

Für das Herstellen von elektrisch leitfähigen Folien sind verschiedene Verfahren etabliert. So können elektrisch leitfähige Folien beispielsweise durch mechanisches Walzen eines elektrisch leitfähigen Ausgangsmaterials gefertigt werden. Beschränkt sind derartige Fertigungsprozesse durch die minimal erreichbare Dicke einer solchen Folie. Mittels Walzprozessen können zum Beispiel Folien aus Kupfer mit einer minimalen Dicke von etwa 6 µm hergestellt werden, was für einige Anwendungsfälle jedoch nicht dünn genug ist. Nachteilig wirkt sich hierbei ebenfalls aus, dass die Oberflächen der Folien oftmals mit Riefen vom Walzprozess versehen sind.

Für das Herstellen von elektrisch leitfähigen Folien mit geringerer Foliendicke als 6 µm werden beispielsweise auf flexiblen Substraten mittels Vakuumprozessen Schichtsysteme, welche elektrisch leitfähiges Material aufweisen, abgeschieden und nachfolgend das flexible Substrat abgelöst. In DE 10 2015 003 369 A1 wird vorgeschlagen, zunächst eine Opferschicht auf einem Trägersubstrat und anschließend eine Nutzschicht aus elektrisch leitfähigem Material mittels Vakuumbeschichtungsprozessen auf einem Trägersubstrat abzuscheiden. Das auf diese Weise hergestellte Schichtsystem wird anschließend beispielsweise mit Laser-Strahlen beaufschlagt, was zur Rissbildung in der Opferschicht führt und wodurch die Nutzschicht vom Trägersubstrat getrennt werden kann. Nachteilig wirkt sich hierbei aus, dass auch nach dem Lösen der Nutzschicht vom Trägersubstrat Reste der Opferschicht an der Nutzschicht haften bleiben, was zusätzliche Reinigungsschritte einer auf diese Weise hergestellten elektrisch leitfähigen Folie erfordert.

Aus WO 2017/054889 A1 ist es bekannt, zunächst aus Stabilitätsgründen einen Schichtverbund aus mindestens zwei Schichten, bestehend aus unterschiedlichen Materialien, auf einem flexiblen Substrat mittels Vakuumbeschichtungsprozessen abzuscheiden. Dabei kann beispielsweise Lithium als erste Schicht und Kupfer als zweite Schicht abgeschieden werden. Das flexible Substrat wird anschließend vom Schichtverbund entfernt. Mit dieser Vorgehensweise lässt sich jedoch nur ein Folienverbund aus mindestens zwei verschiedenen Materialien herstellen.

In EP 0 415 206 A2, DE 1 446 270 A1 und WO 2017/054889 A1 sind Verfahren zum Herstellen einer elektrisch leitfähigen Folie offenbart, bei denen ein elektrisch leitfähiges Material mittels eines Vakuumbeschichtungsprozesses auf einem flexiblen Material abgeschieden und die abgeschiedene Schicht nach dem Schichtabscheideprozess vom Substrat abgezogen wird. Nachteilig wirkt sich hierbei aus, dass bei vielen elektrisch leitfähigen Materialien die ausgebildeten Haftungskräfte zwischen Substrat und Schicht ein Abziehen der Schicht vom Substrat verhindern. In DE 1 446 270 A1 wird deshalb vorgeschlagen, vor der Schichtabscheidung einen Ölfilm auf dem Substrat aufzutragen. Das Auftragen eines Ölfilms lässt sich allerdings nicht in einen Vakuumbeschichtungsprozess integrieren, sondern erfordert einen zusätzlichen Arbeitsschritt außerhalb der Vakuumkammer. Des Weiteren birgt ein auf dem Substrat aufgetragener Ölfilm das Risiko in sich, dass das Öl in der Vakuumkammer verdampft und als Verunreinigung in der Schicht eingebunden wird. In WO 2017/054889 A1 wird das Problem der Haftungskräfte zwischen einem Substrat und einer darauf abgeschiedenen elektrisch leitfähigen Schicht gelöst, indem eine Opferschicht zwischen Substrat und Schicht abgeschieden wird. Nachteilig hierbei ist, dass Reste der Opferschicht an der Schicht aus dem elektrisch leitfähigen Material haften bleiben, die in einem zusätzlichen Reinigungsschritt entfernt werden müssen.

Der Erfindung liegt daher das technische Problem zugrunde, ein Verfahren zum Herstellen einer elektrisch leitfähigen Folie zu schaffen, mittels dessen die Nachteile aus dem Stand der Technik überwunden werden können. Insbesondere soll es mit dem erfindungsgemäßen Verfahren auch möglich sein, eine elektrisch leitfähige Folie mit einer Foliendicke kleiner 1 µm herzustellen. Des Weiteren soll die Folie über die Foliendicke betrachtet aus lediglich einem Material bestehen.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren zum Herstellen einer Folie aus einem elektrisch leitfähigem Material, wobei die Folie entlang der Foliendickenausdehnung aus dem gleichen Material besteht, wird zunächst ein flexibles Substrat in eine Arbeitskammer eingebracht. Des Weiteren wird auf zumindest einem Oberflächenbereich des Substrates mittels eines Vakuumbeschichtungsprozesses eine Schicht aus dem elektrisch leitfähigen Material abgeschieden. Hierfür kann beispielsweise ein elektrisch leitfähiges Material verwendet werden, welches mindestens eines der chemischen Elemente aus der Gruppe Kupfer, Indium, Aluminium, Zinn, Zink, Magnesium, Silber aufweist. Besonders geeignet ist das erfindungsgemäße Verfahren zum Herstellen von Kupferfolien. Als Vakuumbeschichtungsprozess dient das Magnetronsputtern und das Verdampfen für das Abscheiden der Schicht aus dem elektrisch leitfähigen Material. Als flexibles Substrat sind Metallfolien (insbesondere aus Edelstahl), Kunststofffolien, Glas oder Papier geeignet.

Nach dem Abscheiden einer ersten Schicht aus dem elektrisch leitfähigen Material wird die erste Schicht mit mechanischen Mitteln von dem flexiblen Substrat abgezogen. Überraschend hat sich gezeigt, dass eine einzelne, direkt auf einem flexiblen Substrat mittels Vakuumbeschichtungsprozessen abgeschiedene Schicht aus einem elektrisch leitfähigen Material vom flexiblen Substrat mechanisch abgezogen werden kann, wenn die Haftkraft zwischen dem flexiblen Substrat und der abgeschiedenen Schicht derart eingestellt wird, dass diese Haftkraft geringer ist als die Bindungskräfte innerhalb der abgeschiedenen Schicht und geringer ist als die Bindungskräfte innerhalb des flexiblen Substrates.

Erfindungsgemäß wird eine für das Abziehen erforderliche Haftkraft zwischen flexiblem Substrat und abgeschiedener Schicht eingestellt, indem ein lonenätzprozess auf zumindest dem Oberflächenbereich des flexiblen Substrates ausgeübt wird, auf dem die Schicht aus elektrisch leitfähigem Material abgeschieden werden soll. Das Ionenätzen bewirkt einerseits das Reinigen des Substratoberflächenbereichs und verändert andererseits die Oberflächenstruktur des Substrates, was sich dann vorteilhaft auf nachfolgende Verfahrensschritte auswirkt. Für das Ionenätzen können beispielsweise Ionen, beispielsweise herrührend aus einem Hohlkathodenplasma oder einem Magnetronplasma, verwendet werden.

Mittels des Ionenätzprozesses wird vermutlich eine Oberflächenrauheit am Substrat geschaffen, welche das mechanische Abziehen der einzelnen Schicht aus elektrisch leitfähigem Material vom flexiblen Substrat ermöglicht.

Zusätzlich zum Ionenätzen des Substrates vor der Schichtabscheidung kann die Schicht aus elektrisch leitfähigem Material während und/oder nach der Schichtabscheidung erhitzt werden, wodurch die Haftkraft zwischen flexiblem Substrat und abgeschiedener Schicht verringert und dadurch das Abziehen der abgeschiedenen Schicht vom flexiblen Substrat ermöglicht wird. Hierfür wird erfindungsgemäß die Schicht aus elektrisch leitfähigem Material in mindestens zwei Teilschichten abgeschieden, wobei eine erste Teilschicht der Schicht mittels eines ersten Vakuumbeschichtungsprozesses und eine zweite Teilschicht der Schicht mittels eines zweiten Vakuumbeschichtungsprozesses abgeschieden wird, wobei der zweite Vakuumbeschichtungsprozess mit einer stärkeren Wärmeentwicklung einhergeht als der erste Vakuumbeschichtungsprozess.

Die erfindungsgemäße Vorgehensweise ermöglicht auch das mechanische Abziehen des flexiblen Substrates, wenn vor dem Abziehen des flexiblen Substrates eine Schicht aus einem anderen Material auf die Schicht aus elektrisch leitfähigem Material oder auch mehrere Schichten aus einem anderen Material auf der Schicht aus elektrisch leitfähigem Material abgeschieden werden.

Das erfindungsgemäße Verfahren ist insbesondere für das Herstellen von elektrisch leitfähigen Folien mit einer Foliendicke kleiner 3 µm geeignet. Mittels des erfindungsgemäßen Verfahrens konnten sogar elektrisch leitfähige Folien (insbesondere Kupferfolien) mit einer Foliendicke kleiner 1 µm hergestellt werden.

Die vorliegende Erfindung wird nachfolgend anhand von Ausführungsbeispielen näher erläutert. Die Fig. zeigen
- Fig. 1: eine schematische Darstellung einer Vorrichtung zum Ausführen von Schritten des erfindungsgemäßen Verfahrens,
- Fig. 2: eine schematische Darstellung einer alternativen Vorrichtung zum Ausführen von Schritten des erfindungsgemäßen Verfahrens.

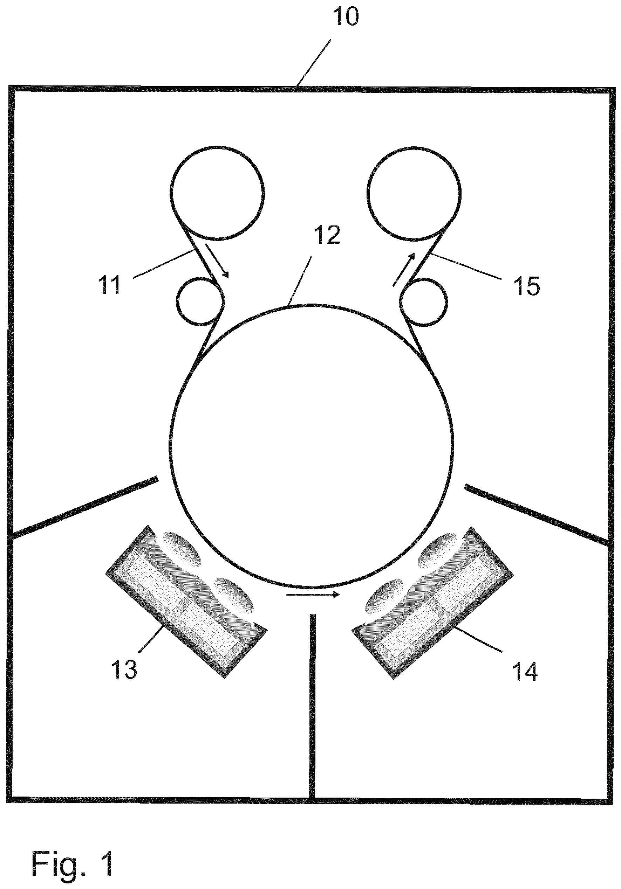

In Fig. 1 ist ein Vorrichtung schematisch dargestellt, mittels welcher Schritte eines Verfahrens durchgeführt werden können, das nicht **Teil** der Ansprüche ist.

In einer Vakuumarbeitskammer 10 wird zunächst ein bandförmiges, flexibles Substrat 11, welches als Kunststofffolie ausgebildet ist, derart eingebracht, dass es nach dem Abwickeln von einer Abwickelrolle und dem Vorbeiführen an einer oder mehreren Umlenkrollen eine Kühlwalze 12 teilweise umschlingt. Während das flexible Substrat 11 in einem Rolle-zu-Rolle-Prozess entlang des Kühlwalzenumfangs bewegt wird, passiert das flexible Substrat zwei Prozessstationen. Die erste Prozessstation weist ein Magnetron 13 auf, mit welchem ein Magnetronplasma in einer sauerstoffhaltigen Atmosphäre erzeugt wird. Das Magnetron 13 wird dabei mit bekannten Prozessparametern derart betrieben, dass am Magnetron 13 kein Sputterabtrag entsteht, der sich auf dem flexiblen Substrat 12 niederschlägt, sondern dass lediglich die Sauerstoffionen aus dem Magnetronplasma zur Substratoberfläche hin beschleunigt werden und somit einen Ionenätzprozess auf der Substratoberfläche ausüben. Damit wird zum einen die Oberfläche des flexiblen Substrates 11 gereinigt und zum anderen die Struktur der Substratoberfläche verändert.

Die zweite Prozessstation, welche der ersten Prozessstation in Bewegungsrichtung des Substrates 11 betrachtet nachfolgt, weist ein Magnetron 14 mit einem Kupfer-Target auf. Mit dem Magnetron 14 werden mittels bekannter Prozessschritte Kupferpartikel vom Kupfer-Target abgestäubt, welche sich als Kupferschicht auf dem flexiblen Substrat 11 niederschlagen. Das Magnetron 14 kann dabei vorzugsweise derart betrieben werden, dass eine Kupferschicht mit einer Schichtdicke vom zweistelligen Nanometerbereich bis zum einstelligen Mikrometerbereich auf dem flexiblen Substrat 11 abgeschieden wird. Nach dem Abscheiden der Kupferschicht wird der Verbund 15, bestehend aus dem flexiblen Substrat 11 und der Kupferschicht, nach dem Vorbeiführen an einer oder mehrerer Umlenkrollen auf einer Aufwickelrolle aufgewickelt.

Nach dem vollständigen Beschichten des bandförmigen, flexiblen Substrates 11 mit einer Kupferschicht wird die Rolle mit dem Verbund 15 aus der Arbeitskammer 10 entnommen und die Kupferschicht vom als Kunststofffolie ausgebildeten flexiblen Substrat 11 mechanisch abgezogen. Hierzu kann beispielsweise die Rolle, auf welcher der Verbund 15 aufgewickelt ist, auf eine glatte Unterlage gelegt werden. Der Anfang des bandförmigen Verbundes 15 wird ein wenig von der Rolle abgewickelt und mit der Substratseite des Verbundes nach unten auf die glatte Unterlage gelegt. Kurz vor dem Bandende des Verbundes 15 wird mit einem scharfen Schneidwerkzeug die Kupferschicht quer zur Bandrichtung durchschnitten, ohne das Substrat 11 zu durchschneiden. Biegt man den Verbund 15 entlang der Schnittlinie in Richtung der Seite des Substrates 11, lässt sich ein Anfang finden, an welchem die Kupferschicht per Hand von der Kunststofffolie abgezogen werden kann. Die auf diese Weise gewonnenen Enden der voneinander separierten Kunststofffolie und der Kupferschicht können anschließend in einem Bandwickelwerk auf separate Rollen aufgewickelt und mittels des Bandwickelwerkes dann entlang des gesamten bandförmigen Verbundes 15 die Kupferschicht vom flexiblen Substrat 11 abgezogen werden. Infolgedessen entsteht eine auf einer Rolle aufgewickelte elektrisch leitfähige Folie, welche entlang der Foliendickenausdehnung aus dem gleichen Material und in diesem Ausführungsbeispiel aus Kupfer besteht.

Das zuvor beschriebene Abziehen der Kupferschicht vom flexiblen Substrat 11 am Anfang des Verbundes 15 per Hand ist hier nur beispielhaft beschrieben. Es sind auch Vorrichtungen bekannt, mit denen die Kupferschicht auch vom Beginn des Verbundes 15 vom flexiblen Substrat 11 abgezogen werden kann.

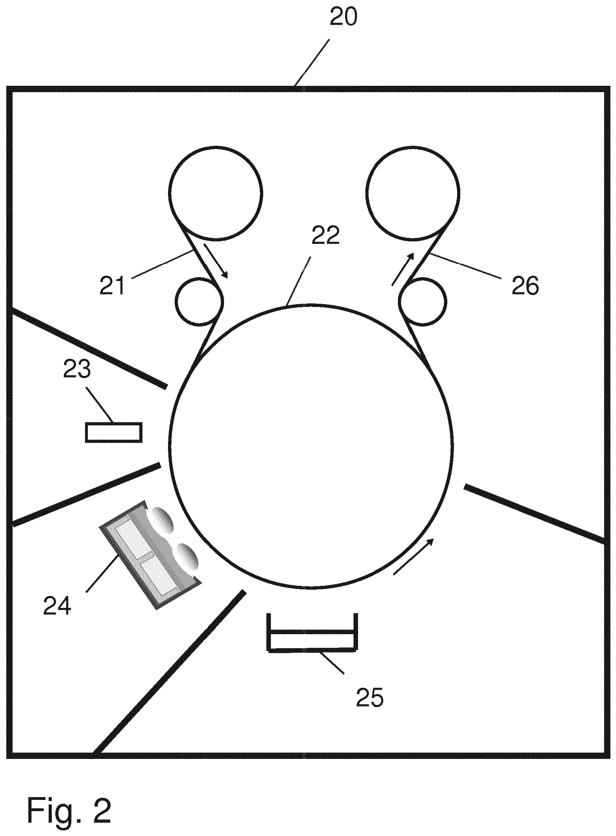

In Fig. 2 ist eine Vorrichtung schematisch dargestellt, mit welcher das erfindungsgemäße Verfahren ausführbar ist. **In** einer Arbeitskammer 20 wird zunächst ein bandförmiges, flexibles Substrat 21, welches als Edelstahlfolie ausgebildet ist, derart eingebracht, dass es nach dem Abwickeln von einer Abwickelrolle und dem Vorbeiführen an einer oder mehreren Umlenkrollen eine Kühlwalze 22 teilweise umschlingt. Während das flexible Substrat 21 in einem Rolle-zu-Rolle-Prozess entlang des Kühlwalzenumfangs bewegt wird, passiert das flexible Substrat 21 drei Prozessstationen. Die erste Prozessstation weist eine Hohlkathodenanordung 23 auf, mit welcher ein Hohlkathodenplasma erzeugt wird. Die Ionen aus dem Hohlkathodenplasma werden zur Substratoberfläche hin beschleunigt und üben somit einen Ionenätzprozess auf der Substratoberfläche aus. Damit wird zum einen die Oberfläche des flexiblen Substrates 21 gereinigt und zum anderen die Struktur der Substratoberfläche verändert.

Die zweite Prozessstation, welche der ersten Prozessstation in Bewegungsrichtung des Substrates 21 betrachtet nachfolgt, weist ein Magnetron 24 mit einem Kupfer-Target auf. Mit dem Magnetron 24 werden mittels bekannter Prozessschritte Kupferpartikel vom Kupfer-Target abgestäubt, welche sich als erste Kupferteilschicht auf dem flexiblen Substrat 21 niederschlagen. Das Magnetron 24 kann dabei vorzugsweise derart betrieben werden, dass die erste Kupferteilschicht mit einer Schichtdicke im zweistelligen Nanometerbereich auf dem flexiblen Substrat 21 abgeschieden wird.

Nach dem Abscheiden der ersten Kupferteilschicht wird das Substrat 21 an einer dritten Prozessstation vorbeigeführt. Diese umfasst ein Gefäß 25, in welchem Kupfer verdampft wird, welches sich als zweite Kupferteilschicht auf dem Substrat 24 niederschlägt. Bei einer Ausführungsform wird eine zweite Kupferteilschicht mit einer Schichtdicke im zweistelligen Nanometerbereich oder einstelligem Mikrometerbereich abgeschieden. Für das Verdampfen des Kupfers im Gefäß 25 sind beispielsweise Prozesse des thermischen Verdampfens, bei welchen das gesamte, sich im Gefäß 25 befindende Kupfer, erhitzt wird, oder Prozesse des Verdampfens mittels eines Elektronenstrahls geeignet.

Es ist bekannt, dass Verdampfungsprozesse üblicherweise mit einer größeren Hitzeentwicklung als beim Magnetronsputtern einhergehen, welche ein zu beschichtendes Substrat und sich darauf bereits befindende Schichten erwärmen. Beim erfindungsgemäßen Verfahren bewirkt der Verdampfungsprozess ein Erhitzen des flexiblen Substrates 21 und der ersten Kupferteilschicht auf etwa 300 °C, was zu einer Gefügeänderung der ersten Kupferteilschicht führt, womit eine Verringerung der Haftfestigkeit der ersten Kupferteilschicht auf dem flexiblen Substrat 21 einhergeht und was sich vorteilhaft auf nachfolgende Prozessschritte auswirkt. Die im zweiten Ausführungsbeispiel beschriebene Vorgehensweise ist daher besonders vorteilhaft beim Herstellen von elektrisch leitfähigen Folien aus Materialien, welche einen ähnlichen bzw. einen noch geringeren Schmelzpunkt als Kupfer aufweisen. Bei einer Ausführungsform der Erfindung wird daher ein elektrisch leitfähiges Material verwendet, welches mindestens eines der chemischen Elemente aus der Gruppe Kupfer, Indium, Aluminium, Zinn, Zink, Magnesium, Silber enthält.

Nach dem Abscheiden der zweiten Kupferteilschicht wird der Verbund 26, bestehend aus dem flexiblen Substrat 21 sowie der ersten und zweiten Kupferteilschicht, nach dem Vorbeiführen an einer oder mehrerer Umlenkrollen auf einer Aufwickelrolle aufgewickelt. Nach dem vollständigen Beschichten des bandförmigen, flexiblen Substrates 21 mit der ersten und zweiten Kupferteilschicht wird die Rolle mit dem Verbund 26 aus der Arbeitskammer 20 entnommen und die Kupferschicht, bestehend aus erster und zweiter Kupferteilschicht, vom als Edelstahlfolie ausgebildeten flexiblen Substrat 21 mechanisch abgezogen. Hierzu kann beispielsweise die Rolle, auf welchem der Verbund 26 aufgewickelt ist, auf eine glatte Unterlage gelegt werden. Der Anfang des bandförmigen Verbundes 26 wird ein wenig von der Rolle abgewickelt und mit der Edelstahlseite des Verbundes nach unten auf die glatte Unterlage gelegt. Kurz vor dem Bandende des Verbundes 26 wird mit einem scharfen Schneidwerkzeug die Kupferschicht quer zur Bandrichtung durchschnitten, ohne die Edelstahlfolie zu durchschneiden. Biegt man den Verbund 26 entlang der Schnittlinie in Richtung der Seite der Edelstahlfolie, lässt sich ein Anfang finden, an welchem die Kupferschicht per Hand von der Edelstahlfolie abgezogen werden kann. Die auf diese Weise gewonnenen Enden der voneinander separierten Edelstahlfolie und der Kupferschicht können anschließend in einem Bandwickelwerk auf separate Rollen aufgewickelt und mittels des Bandwickelwerkes dann entlang des gesamten bandförmigen Verbundes 26 die Kupferschicht vom flexiblen Substrat 21 abgezogen werden. Infolgedessen entsteht eine auf einer Rolle aufgewickelte elektrisch leitfähige Folie, welche entlang der Foliendickenausdehnung aus dem gleichen Material und in diesem Ausführungsbeispiel aus Kupfer besteht. Beim zuvor beschriebenen nicht-erfindungsgemäßen Ausführungsbeispiel waren die zweite und dritte Prozessstation Bestandteile ein und derselben Anlage. Das erfindungsgemäße Verfahren kann alternativ auch durchgeführt werden, wenn die zweite und dritte Prozessstation Bestandteile separater Anlagen sind.

## Patentansprüche

1. Verfahren zum Herstellen einer Folie aus einem elektrisch leitfähigen Material, wobei die Folie entlang der Foliendickenausdehnung aus dem gleichen elektrisch leitfähigen Material besteht, wobei folgende Verfahrensschritte ausgeführt werden:
a) einbringen eines flexiblen Substrates (11; 21) in eine Arbeitskammer (10; 20);
b) abscheiden einer Schicht aus dem elektrisch leitfähigen Material auf zumindest einem Oberflächenbereich des flexiblen Substrates (11; 21) mittels eines Vakuumbeschichtungsprozesses;
c) abziehen der ersten Schicht vom flexiblen Substrat (11; 21);
**dadurch gekennzeichnet, dass**
d) vor dem Abscheiden der Schicht aus dem elektrisch leitfähigen Material ein Ionenätzprozess zumindest auf dem Oberflächenbereich des flexiblen Substrates (11) ausgeübt wird, und wobei eine erste Teilschicht der Schicht mittels eines ersten Vakuumbeschichtungsprozesses und eine zweite Teilschicht der Schicht mittels eines zweiten Vakuumbeschichtungsprozesses abgeschieden wird, wobei der zweite Vakuumbeschichtungsprozess mit einer stärkeren Wärmeentwicklung einhergeht als der erste Vakuumbeschichtungsprozess und wobei die erste Teilschicht der Schicht mittels Magnetronsputtern und die zweite Teilschicht der Schicht mittels Verdampfen abgeschieden werden.

2. Verfahren nach Anspruch 1, **dadurch gekennzeichnet, dass** eine Metallfolie als flexibles Substrat (21) verwendet wird.

3. Verfahren nach Anspruch 2, **dadurch gekennzeichnet, dass** eine Edelstahlfolie als flexibles Substrat (21) verwendet wird.

4. Verfahren nach Anspruch 1, **dadurch gekennzeichnet, dass** eine Kunststofffolie als flexibles Substrat (11) verwendet wird.

5. Verfahren nach Anspruch 1, **dadurch gekennzeichnet, dass** Glas oder Papier als flexibles Substrat verwendet wird.

6. Verfahren nach einem der vorhergehenden Ansprüche, **dadurch gekennzeichnet, dass** die Schicht mit einer Schichtdicke kleiner 3 µm abgeschieden wird.

7. Verfahren nach Anspruch 6, **dadurch gekennzeichnet, dass** die Schicht mit einer Schichtdicke kleiner 1 µm abgeschieden wird.

8. Verfahren nach einem der vorhergehenden Ansprüche, **dadurch gekennzeichnet, dass** ein bandförmiges flexibles Substrat (11; 21) verwendet wird.

9. Verfahren nach Anspruch 8, **dadurch gekennzeichnet, dass** die Schicht mittels eines Rolle-zu-Rolle-Prozesses abgeschieden wird.

10. Verfahren nach einem der vorhergehenden Ansprüche, **dadurch gekennzeichnet, dass** ein elektrisch leitfähiges Material verwendet wird, welches mindestens eines der chemischen Elemente aus der Gruppe Kupfer, Indium, Aluminium, Zinn, Zink, Magnesium, Silber enthält.

11. Verfahren nach Anspruch 10, **dadurch gekennzeichnet, dass** Kupfer als elektrisch leitfähiges Material verwendet wird.

## Claims

1. Method for producing a film from an electrically conductive material, wherein the film consists of the same electrically conductive material along the film thickness extent, wherein the following method steps are carried out:
a) introducing a flexible substrate (11; 21) into a working chamber (10; 20);
b) depositing a layer of the electrically conductive material on at least one surface region of the flexible substrate (11; 21) by means of a vacuum coating process;
c) removing the first layer from the flexible substrate (11; 2); **characterized in that**
d) prior to the deposition of the layer of the electrically conductive material, an ion etching process is performed at least on the surface region of the flexible substrate (11), and wherein
a first partial layer of the layer is deposited by means of a first vacuum coating process and a second partial layer of the layer is deposited by means of a second vacuum coating process, wherein the second vacuum coating process is accompanied by a stronger evolution of heat than the first vacuum coating process and wherein
the first partial layer of the layer is deposited by means of magnetron sputtering and the second partial layer of the layer is deposited by means of vapour deposition.

2. Method according to Claim 1, **characterized in that** a metal foil is used as the flexible substrate (21).

3. Method according to Claim 2, **characterized in that** a stainless steel foil is used as the flexible substrate (21).

4. Method according to Claim 1, **characterized in that** a plastic film is used as the flexible substrate (11).

5. Method according to Claim 1, **characterized in that** glass or paper is used as the flexible substrate.

6. Method according to any of the preceding claims, **characterized in that** the layer is deposited with a layer thickness of less than 3 µm.

7. Method according to Claim 6, **characterized in that** the layer is deposited with a layer thickness of less than 1 µm.

8. Method according to any of the preceding claims, **characterized in that** a flexible substrate (11; 21) in strip form is used.

9. Method according to Claim 8, **characterized in that** the layer is deposited by means of a roll-to-roll process.

10. Method according to any of the preceding claims, **characterized in that** an electrically conductive material is used which comprises at least one of the chemical elements from the group of copper, indium, aluminium, tin, zinc, magnesium and silver.

11. Method according to Claim 10, **characterized in that** copper is used as electrically conductive material.

## Revendications

1. Procédé de fabrication d'un film en un matériau électriquement conducteur, le film étant constitué, le long de l'étendue d'épaisseur du film, du même matériau électriquement conducteur, les étapes suivantes étant mises en œuvre :
a) l'introduction d'un substrat flexible (11 ; 21) dans une chambre de travail (10 ; 20) ;
b) le dépôt d'une couche du matériau électriquement conducteur sur au moins une zone de surface du substrat flexible (11 ; 21) au moyen d'un procédé de revêtement sous vide ;
c) le détachement de la première couche du substrat flexible (11 ; 2) ; **caractérisé en ce que**
d) avant le dépôt de la couche du matériau électriquement conducteur, un processus de gravure ionique est appliqué au moins sur la zone de surface du substrat flexible (11), et dans lequel
une première sous-couche de la couche est déposée au moyen d'un premier processus de revêtement sous vide et une deuxième sous-couche de la couche est déposée au moyen d'un deuxième processus de revêtement sous vide, le deuxième processus de revêtement sous vide étant associé à une génération de chaleur plus élevée que le premier processus de revêtement sous vide, et dans lequel la première sous-couche de la couche est déposée par pulvérisation cathodique magnétron et la deuxième sous-couche de la couche est déposée par évaporation.

2. Procédé selon la revendication 1, **caractérisé en ce qu'**une feuille métallique est utilisée comme substrat flexible (21).

3. Procédé selon la revendication 2, **caractérisé en ce qu'**un film d'acier inoxydable est utilisé comme substrat flexible (21).

4. Procédé selon la revendication 1, **caractérisé en ce qu'**un film plastique est utilisé comme substrat flexible (11).

5. Procédé selon la revendication 1, **caractérisé en ce que** du verre ou du papier est utilisé comme substrat flexible.

6. Procédé selon l'une quelconque des revendications précédentes, **caractérisé en ce que** la couche est déposée avec une épaisseur de couche inférieure à 3 µm.

7. Procédé selon la revendication 6, **caractérisé en ce que** la couche est déposée avec une épaisseur de couche inférieure à 1 µm.

8. Procédé selon l'une quelconque des revendications précédentes, **caractérisé en ce qu'**un substrat flexible sous forme de bande (11 ; 21) est utilisé.

9. Procédé selon la revendication 8, **caractérisé en ce que** la couche est déposée au moyen d'un processus rouleau à rouleau.

10. Procédé selon l'une quelconque des revendications précédentes, **caractérisé en ce qu'**un matériau électriquement conducteur est utilisé, lequel contient au moins un des éléments chimiques du groupe constitué par le cuivre, l'indium, l'aluminium, l'étain, le zinc, le magnésium et l'argent.

11. Procédé selon la revendication 10, **caractérisé en ce que** du cuivre est utilisé comme matériau électriquement conducteur.
